# EUROPEAN PATENT APPLICATION

(11) **EP 3 985 143 A1**
(43) Date of publication of application: **20.04.2022**
(21) Application number: 20836223.6
(22) Date of filing: 10.07.2020
(51) Int. Cl.: C23C 16/458

(54) **COMPOSITE TRAY**

(30) Priority: 11.07.2019 CN 201910622819
(71) Applicant: Suzhou Maizheng Technology Co. Ltd, Suzhou, Jiangsu 215200 (CN)
(72) Inventor: SUN, Jian, Suzhou, Jiangsu 215200 (CN); ZHOU, Jian, Suzhou, Jiangsu 215200 (CN); CHEN, Chen, Suzhou, Jiangsu 215200 (CN)
(74) Representative: Manitz Finsterwald Patent- und Rechtsanwaltspartnerschaft mbB
(86) International application number: PCT/CN2020/101236
(87) International publication number: WO 2021/004518

(57) **Abstract**

Disclosed is a composite tray, comprising support units and a substrate used for receiving the support units. Each support unit is provided with a silicon wafer placement area used for receiving a silicon wafer; and the substrate and the support units are made of different materials. The composite tray is made of two different materials, and can overcome the defect of a composite tray made of a single material, the performance of the composite tray in the aspects of strength, heat insulation, heat conduction and the like can be met, the cost is lower, and batch use is facilitated.

## Description

### TECHNICAL FIELD

The present application relates to the field of cell manufacturing technology, and more particularly relates to a composite tray.

### BACKGROUND

A composite tray in a silicon wafer coating equipment is an important process device for bearing silicon wafers in PECVD (Plasma Enhanced Chemical Vapor Deposition). The composite tray in the prior art is generally made of one material, for example, the composite tray is made of a C/C (carbon/carbon) composite material. The C/C composite material is a novel high-performance structural and functional composite material and has excellent characteristics of high strength, high modulus, high fracture toughness, high heat conduction, excellent heat insulation, low density, and the like. However, due to the high price of the composite tray made of the C/C composite material, requiring the number of the composite trays made of C/C composite materials to be multiple will inevitably increase investment, increase costs and maintenance costs. In addition, burrs formed on the composite trays will scratch the silicon wafer. In addition, the composite tray made of the C/C composite material also absorbs water and moisture, which affects the coating process. The composite tray may be made of aluminum alloy material, but the single aluminum alloy material deforms greatly and conducts heat too quickly. Or, the composite tray may be made of graphite material, and the single graphite material has no burrs and less water absorption, but has insufficient strength.

### SUMMARY

The purpose of the present application is to provide an improved composite tray in view of the problems in the prior art.

In order to achieve the above purpose, the technical solutions adopted by the present application are as follows.

A composite tray includes supporting components and a base configured for receiving the supporting components. Each of the supporting components is provided with a silicon wafer receiving area configured for receiving a silicon wafer, and the base and the supporting components are made of different materials.

Preferably, the base is made of C/C composite material, and the supporting component is made of graphite material.

Preferably, the base is provided with a groove configured for receiving the supporting component, and the groove extends through one end surface of the base.

Preferably, the base is provided with openings configured for receiving the supporting component, and the openings extend through opposite two end surfaces of the base.

Preferably, the supporting component is detachably connected to the base.

Further, the composite tray further includes a connecting element configured to connect the base with the supporting component, and the connecting element is a bolt, a hook, a buckle, or a sheet metal pressing strip.

Further, the base is connected to the supporting component by transition fit.

Preferably, there are a plurality of supporting components, and the plurality of supporting components are arranged independently from each other.

Further, the two adjacent supporting components have overlapping areas that overlap with each other. The two adjacent supporting components are connected through a set of connecting elements, and the connecting elements are disposed at positions of the overlapping areas.

Preferably, there are a plurality of supporting components, and each of the supporting components is integrally formed with at least one adjacent supporting component to form a connected-piece structure.

Further, the two adjacent supporting components have overlapping areas that overlap with each other. The two adjacent supporting components are connected through a set of connecting elements, and the connecting elements are disposed at positions of the overlapping areas.

Preferably, there are a plurality of supporting components, the plurality of supporting components are arranged on the base in a matrix form.

Preferably, the supporting components have a plurality of specifications, and the supporting components of the plurality of specifications are replaceably arranged on the base.

Further, the silicon wafer receiving area of the supporting component is provided with cutting grooves on four corners thereof.

Further, the silicon wafer receiving area of the supporting component is provided with chamfers or fillets on four corners thereof.

Further, the supporting components of the plurality of specifications have different sizes of the silicon wafer receiving areas.

Due to the application of the aforementioned technical solutions, the present application has the following advantages compared with the prior art: the composite tray according to the present application is made of two different materials, and thus can overcome the defects of the composite tray made of a single material, which can not only meet the performances of strength, heat insulation, heat conduction, and the like, but also has relatively low cost and is beneficial to batch use.

### BRIEF DESCRIPTION OF THE DRAWINGS

FIG. 1 is a perspective view of a composite tray of the present application;
FIG. 2 is a front view of a composite tray of the present application;
FIG. 3 is a partial enlarged view of a portion A of FIG. 2;
FIG. 4 is a cross-sectional view taken along line A-A of FIG. 3;
FIG. 5 is a partial enlarged view of a portion A of FIG. 4;
FIG. 6 is a schematic view of a supporting component (on which a right-angle silicon wafer is placed) of the present application;
FIG. 7 is a partial enlarged view of a portion A of FIG. 6;
FIG. 8 is a schematic view of a supporting component (on which a chamfered silicon wafer is placed) of the present application;
FIG. 9 is a partial enlarged view of a portion A of FIG. 8;
FIG. 10 is a schematic view of a connection structure between a base and a supporting component of the present application; and
FIG. 11 is a partial enlarged view of a portion A of FIG. 10.

### DETAILED DESCRIPTION OF THE EMBODIMENTS

The technical solutions of the present application are further explained below with reference to the accompanying drawings.

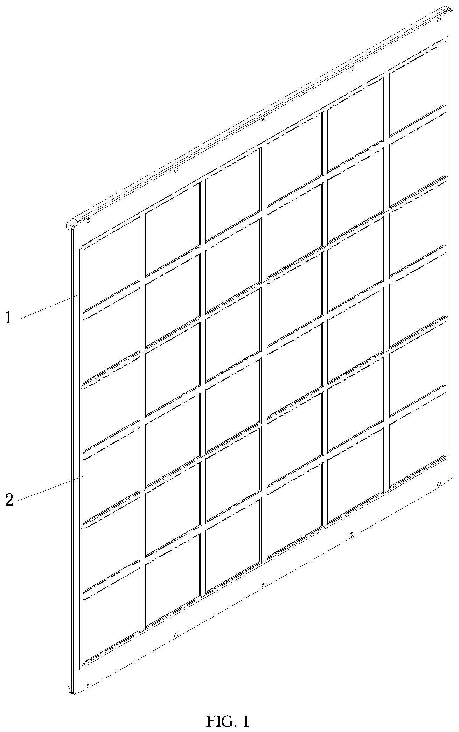

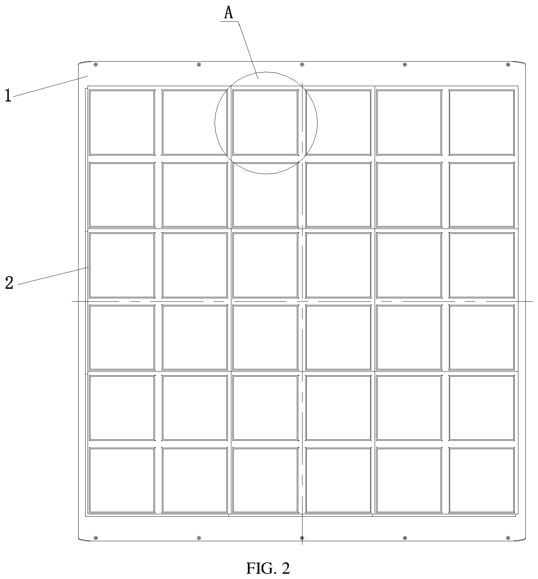

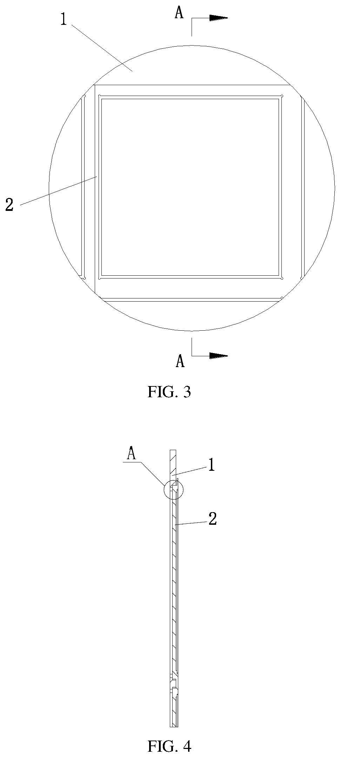

Referring to FIGS. 1 to 5, a composite tray includes a base 1 and a supporting component 2 disposed on the base 1.

The base 1 and the supporting component 2 are made of different materials. In this embodiment, the base 1 is made of a C/C composite material, and the supporting component 2 is made of a graphite material, so that the composite tray not only has the excellent characteristics of high strength, high modulus, high fracture toughness, high heat conduction, excellent heat insulation, low density, and the like of the C/C composite material, but also has the characteristics of low cost, low water absorption, and no burrs of the graphite material. As a result, the production cost of the composite tray is low, and during the silicon wafer coating process, the performance of the composite tray has the least influence on a silicon wafer coating process.

The base 1 is provided with a plurality of receiving portions, preferably, the plurality of receiving portions are arranged in a matrix form, each of which is provided with one supporting component 2 therein. In this embodiment, the receiving portion may be a groove provided on the base 1, where the groove only extends through one end surface of the base 1. The receiving portion may also be an opening provided on the base 1, and the opening extends through the opposite two end surfaces of the base 1. The supporting component 2 is further provided with a silicon wafer receiving area for receiving the silicon wafer 100. When the silicon wafer 100 is coated, the supporting component 2 is mounted in the receiving portion on the base 1, and the silicon wafer 100 is placed in the silicon wafer receiving area on the supporting component 2.

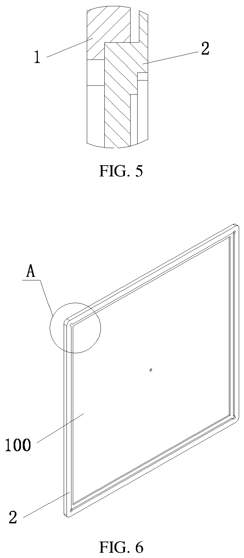

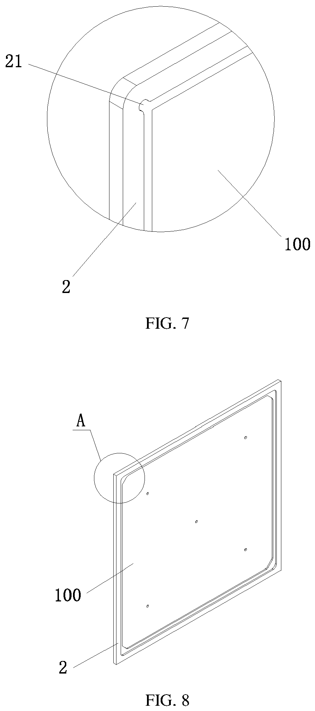

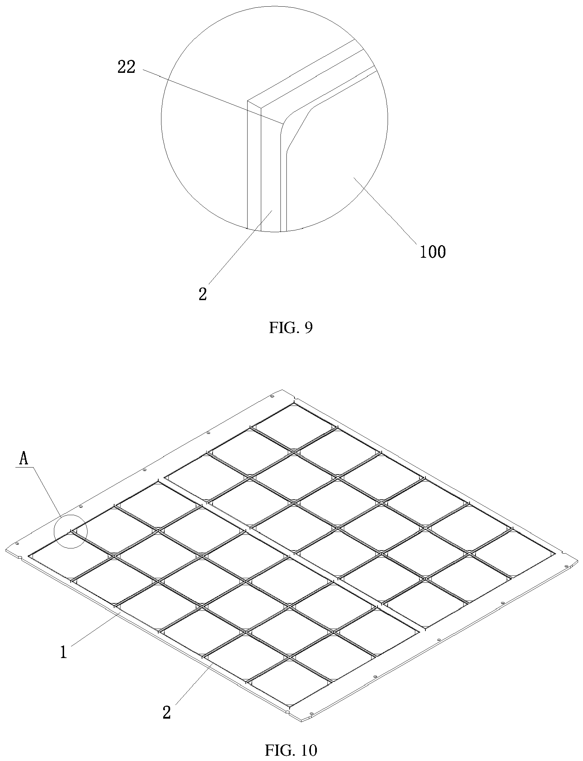

The base 1 and the supporting component 2 are detachably connected such that the supporting component 2 can be replaced. The supporting component 2 has a variety of specifications, the structures of the parts, connected with the base 1, of the supporting components 2 of various specifications are kept consistent. The structures and the sizes of the silicon wafer receiving areas of the supporting components 2 of various specifications are determined according to different sizes or different structures of the silicon wafers 100, as long as the silicon wafer receiving areas are matched with the silicon wafers 100 required to be placed. For example, when the silicon wafer 100 is a right-angle silicon wafer, the silicon wafer receiving area of the supporting component 2 is provided with cutting grooves 21 on four corners thereof to prevent right angle corners of the silicon wafer 100 from being damaged, as shown in FIGS. 6 and 7. Alternatively, when the silicon wafer 100 has corners with a radius of R, the silicon wafer receiving area of the supporting component 2 is provided with chamfers 22 or fillets 22 on the four corners thereof, as shown in FIGS. 8 and 9. Alternatively, the sizes of the silicon wafer receiving areas of the supporting components 2 of various specifications are different.

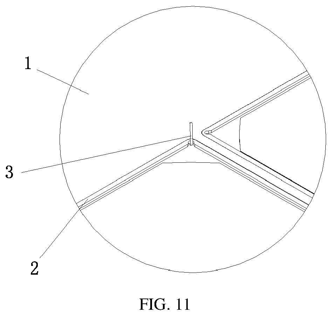

The composite tray further includes a connecting element 3 for connecting the base 1 and the supporting component 2. The connecting element 3 can be a bolt, a hook, a buckle, or a sheet metal pressing strip, as shown in FIGS. 10 and 11. Of course, the base 1 and the supporting component 2 can also be connected by transition fit, so that the connecting element 3 does not need to be provided.

The supporting components 2 can be arranged independently from each other, i.e., the supporting components 2 are of a one-piece structure. It is also possible that each supporting component 2 is integrally formed with at least one adjacent supporting component 2 to form a connected-piece structure. In this embodiment, the base 1 is provided with 36 receiving portions, that is, the composite tray includes 36 supporting components. The 36 supporting components 2 and the 36 receiving portions are all arranged in a 6×6 matrix form. In this case, the supporting components 2 can form a connected-piece structure such as 1×2, 1×3, 1×4, 1×5..., 2×3, 2×4, 2×5..., 3×3, 3×4, 3×5, 3×6..., 4×4, 4×5, 4×6... ..., and the like. When the supporting component 2 adopts a connected-piece structure, the number of the connecting structures between the supporting component 2 and the base 1 can be reduced, thereby facilitating the mounting and the disassembly of the supporting component 2. In addition, the exposed area of the base 1 made of the C/C composite material in the coating process can also be reduced, thereby facilitating the coating process.

The two adjacent one-piece supporting components 2 or the two adjacent connected-piece supporting components 2 have overlapping areas that overlap with each other, so that the base 1 made of the C/C composite material is not exposed in the coating process, thereby facilitating the coating process. In addition, the two adjacent one-piece supporting components 2 or the two adjacent connected-piece supporting components 2 are connected through a set of connecting elements 3. The connecting elements 3 are disposed at the position of the overlapping area, which can also reduce the number of connecting elements 3 between the supporting component 2 and the base 1, thereby facilitating the mounting and disassembly of the supporting component 2.

The above-mentioned embodiments are only to illustrate the technical concept and features of the present application, and their purpose is to enable those skilled in the art to understand the content of the present application and implement the present application, and cannot limit the protection scope of the present application. All equivalent changes or modifications made according to the spirit of the present disclosure should be covered by the protection scope of the present disclosure.

## Claims

1. A composite tray, comprising supporting components and a base configured for receiving the supporting components,
wherein each of the supporting components is provided with a silicon wafer receiving area configured for receiving a silicon wafer, the base and the supporting components are made of different materials.

2. The composite tray according to claim 1, wherein the base is made of C/C (carbon/carbon) composite material, and the supporting component is made of graphite material.

3. The composite tray according to claim 1, wherein the base is provided with a groove configured for receiving the supporting component, and the groove extends through one end surface of the base.

4. The composite tray according to claim 1, wherein the base is provided with openings configured for receiving the supporting component, and the openings extend through opposite two end surfaces of the base.

5. The composite tray according to claim 1, wherein the supporting component is detachably connected to the base.

6. The composite tray according to claim 5, further comprising a connecting element configured to connect the base with the supporting component, and the connecting element is a bolt, a hook, a buckle, or a sheet metal pressing strip.

7. The composite tray according to claim 5, wherein the base is connected to the supporting component by transition fit.

8. The composite tray according to claim 1, wherein there are a plurality of supporting components, and the plurality of supporting components are arranged independently from each other.

9. The composite tray according to claim 8, wherein the two adjacent supporting components have overlapping areas that overlap with each other, the two adjacent supporting components are connected through a set of connecting elements, and the connecting elements are disposed at positions of the overlapping areas.

10. The composite tray according to claim 1, wherein there are a plurality of supporting components, and each of the supporting components is integrally formed with at least one adjacent supporting component to form a connected-piece structure.

11. The composite tray according to claim 10, wherein the two adjacent supporting components have overlapping areas that overlap with each other, the two adjacent supporting components are connected through a set of connecting elements, and the connecting elements are disposed at positions of the overlapping areas.

12. The composite tray according to claim 1, wherein there are a plurality of supporting components, the plurality of supporting components are arranged on the base in a matrix form.

13. The composite tray according to claim 1, wherein the supporting components have a plurality of specifications, and the supporting components of the plurality of specifications are replaceably arranged on the base.

14. The composite tray according to claim 13, wherein the silicon wafer receiving area of the supporting component is provided with cutting grooves on four corners thereof.

15. The composite tray according to claim 13, wherein the silicon wafer receiving area of the supporting component is provided with chamfers or fillets on four corners thereof.

16. The composite tray according to claim 13, wherein the supporting components of the plurality of specifications have different sizes of the silicon wafer receiving areas.
